# EUROPÄISCHE PATENTSCHRIFT

(11) **EP 0 977 285 B1**
(45) Veröffentlichungstag und Bekanntmachung des Hinweises auf die Patenterteilung: **09.06.2004**
(21) Anmeldenummer: 99114544.2
(22) Anmeldetag: 23.07.1999
(51) Int. Cl.: H01L 41/083

(54) **Druckbelastete piezoelektrische Aktoreinheit**
Pressure loading for piezoelectric actuator
Charge de pression pour actuateur piezoélectrique

(30) Priorität: 30.07.1998 DE 19834424
(43) Veröffentlichungstag der Anmeldung: 02.02.2000
(73) Patentinhaber: SIEMENS AKTIENGESELLSCHAFT, 80333 München (DE)
(72) Erfinder: Voigt, Andreas, Dr.-Ing., 93055 Regensburg (DE); Frank, Wilhelm, Dipl.-Ing., 96049 Bamberg (DE); Lewentz, Günter, Dipl.-Ing., 93055 Regensburg (DE)

(56) Entgegenhaltungen:
- US-A- 5 004 945

## Beschreibung

Die Erfindung betrifft eine Aktoreinheit mit einem vorgespannten piezoelektrischen Aktor gemäß dem Oberbegriff des Anspruchs 1.

Solche Aktoreinheiten werden u.a. in der Fahrzeugtechnik zum Steuern von Einspritzventilen einer Brennkraftmaschine eingesetzt. So ist aus der DE 38 44 134 A1 ein Stellantrieb für ein Einspritzventil einer Brennkraftmaschine bekannt, bei dem ein piezoelektrischer Aktor in einer Rohrfeder angeordnet ist und von dieser gegen das Gehäuse des Einspritzventils unter Zugbelastung vorgespannt wird. Dieser Aufbau der Aktoreinheit erfordert jedoch einen hohen Montage- und Wartungsaufwand, da bei jedem Ein- und Ausbau die Zugbelastung der Rohrfeder, mit der der piezoelektrische Aktor vorgespannt ist, neu eingestellt werden muß.

Weiterhin führt die Zugbelastung auf die Rohrfeder auch zu einer sehr hohen Materialbeanspruchung der Umfangswandung der Rohrfeder, die insbesondere noch durch die Schwingungen der Rohrfeder, die aus einer Erregung des piezoelektrischen Aktors resultieren, verstärkt wird. Wenn bei der Herstellung der Rohrfederwandung dann zum Beispiel Fehler oder Beschädigung am Wandungsmaterial aufgetreten sind, können diese zu Rissen in der Rohrfeder führen, die die Lebensdauer des Bauteils stark verkürzen. Dies gilt insbesondere für den Fall, daß die Umfangswandung der Rohrfeder mit Aussparungen, wie in der DE 38 44 134 A1 dargestellt, versehen ist, um die Rohrfeder ausreichend elastisch zum Ausführen der vom piezoelektrischen Aktor hervorgerufenen Längsdehnung zu machen. Bei der Fertigung solcher Aussparungen in der Rohrfederwandung können leicht feine Anrisse entstehen, die dann durch die Zugbelastung der Rohrfeder anwachsen und damit zu einem Versagen des Bauteils führen.
Verschiedene Formen von Rohrfedern zum Vorspannen des piezolektrischen Aktors sind aus WO 99/08330 bekannt.
Aus DE 196 53 555 A1 ist ein piezoelektrischer Aktor bekannt, der über eine Rohrfeder gegen seine Ausdehnungsrichtung auf Druck belastet ist. Die Rohrfeder ist dabei auf Zug belastet.

Aufgabe der vorliegenden Erfindung ist es, eine Aktoreinheit mit einem vorgespannten piezoelektrischen Aktor bereitzustellen, die sich insbesondere zum Steuern eines Einspritzventils einer Brennkraftmaschine eignet und sich durch einen geringen Montage- und Wartungsaufwand sowie eine hohe Lebensdauer auszeichnet.

Diese Aufgabe wird bei einer Aktoreinheit durch die Merkmale des Anspruchs 1 gelöst. Gemäß der Erfindung wird ein piezoelektrischer Aktor in einer Aktoreinheit von einer Vorspanneinrichtung eingekapselt, die ein Druckfedermittel in Form einer Rohrfeder aufweist, das den piezoelektrischen Aktor gegen dessen Dehnungsrichtung druckbelastet. Dabei wird die Rohrfeder auf Druck belastet. Der Einsatz einer druckbelasteten Rohrfeder zum Vorspannen des piezoelektrischen Aktors sorgt für eine wesentliche Reduzierung der Materialbeanspruchung bei der Vorspanneinrichtung im Vergleich zu einer zugbelasteten Ausführung, da durch die Druckspannung keine Risse in der Rohrfeder entstehen. Weiterhin erleichtert die Verkapselung des piezoelektrischen Aktors in der Vorspanneinrichtung den Transport, die Montage sowie die Wartung der Aktoreinheit, wobei insbesondere vorteilhaft ist, daß die Vorspannung des piezoelektrischen Aktors bereits bei der Herstellung der Baueinheit auf Dauer festgelegt wird.

Gemäß einer bevorzugten Ausführungsform weist die Vorspanneinrichtung zwei mit ihren offenen Enden ineinander geschobene becherförmige Hohlformen auf, die jeweils formund/oder kraftschlüssig mit einem Ende des piezoelektrischen Aktors verbunden sind, wobei das Druckfedermittel zwischen den beiden Hohlformen druckbelastet angeordnet ist. Diese Ausgestaltung ermöglicht einen in bezug auf seine Länge besonders kompakten Aufbau der Aktoreinheit, wobei sich außer dem eine günstige und materialschonende Druckverteilung einstellt.

Gemäß einer weiteren bevorzugten Ausführungsform ist der piezoelektrische Aktor und das Drucktedermittel in einer becherförmigen Hohlform eingeschlossen, wobei das ringförmig ausgebildete Druckfedermittel den piezoelektrischen Aktor gegen einen nach innen vorspringenden umlaufenden Randbereich der Hohlform druckbelastet abstützt. Diese Ausführungsform läßt eine besonders schmale Ausgestaltung der Aktoreinheit zu und zeichnet sich weiterhin durch eine hohe Dauerfestigkeit und einfache Herstellung aus.

Weitere vorteilhafte Ausgestaltungen der Aktoreinheit sind in den abhängigen Ansprüchen offenbart.

Die Erfindung wird anhand der Zeichnung näher erläutert. Es zeigen:
Fig. 1 einen Längsschnitt durch eine erste Ausführungsform der erfindungsgemäßen Aktoreinheit;
Fig. 2A einen Längsschnitt durch eine zweite Ausführungsform der erfindungsgemäßen Aktoreinheit;
Fig. 2B einen Querschnitt entlang der A-A Linie bei der Ausführungsform gemäß Fig. 2A; und
Fig. 3 einen Längsschnitt durch eine dritte Ausführungsform der erfindungsgemäßen Aktoreinheit.

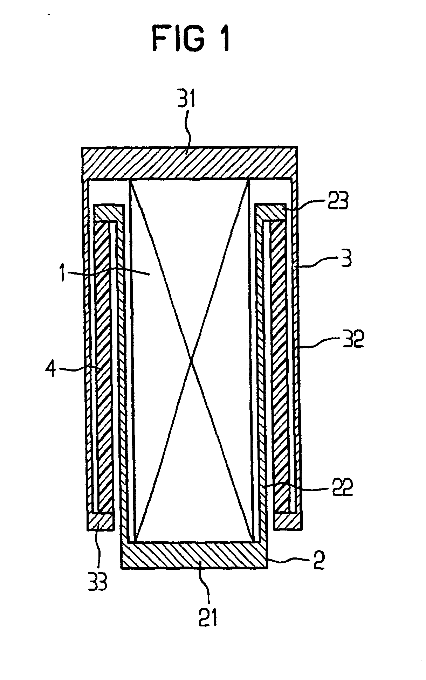

Fig. 1 zeigt im Längsschnitt einen piezoelektrischen Aktor 1, der aus mehreren übereinandergestapelten piezoelektrischen Einzelelementen aufgebaut sein kann. Der piezoelektrische Aktor 1 ist in einer Vorspanneinrichtung verkapselt, die aus einer inneren becherförmigen Hohlform 2, einer äußeren becherförmigen Hohlform 3 und einem zwischen den beiden Hohlformen angeordnetes Druckfedermittel 4 besteht. Die innere Hohlform 2 weist eine Bodenplatte 21 auf, die mit der einen Stirnfläche des piezoelektrischen Aktors 1 kraft- und/oder formschlüssig verbunden ist. An die Bodenplatte 21 der inneren Hohlform schließt sich eine Umfangswandung 22 an, die sich nahezu über die gesamte Länge des piezoelektrischen Aktors 1 erstreckt und von einem nach außen vorspringenden umlaufenden Randbereich 23 abgeschlossen ist. Die äußere Hohlform 3 weist ebenfalls eine Bodenplatte 31 auf, die kraftund/oder formschlüssig mit der anderen Stirnfläche des piezoelektrischen Aktors 1 verbunden ist, wobei die Stirnfläche mittig an der Bodenplatte anliegt. Mit der Bodenplatte 31 der äußeren Hohlform 3 ist eine Umfangswandung 32 verbunden, die sich ebenfalls im wesentlichen über die gesamte Länge des piezoelektrischen Aktors 1 erstreckt und die Umfangswandung 22 der inneren Hohlform 2 bis nahe an deren Bodenplatte 21 mit umfaßt. Die Umfangswandung 32 der äußeren Hohlform 3 wird von einem umlaufenden verbreiterten Randbereich 33 abgeschlossen, der von der Umfangswandung nach innen in Richtung auf die Umfangswandung 22 der inneren Hohlform 2 vorsteht. Das Druckfedermittel 4 ist zwischen den vorspringenden Randbereichen 23, 33 der Hohlformen 2, 3 angeordnet und wird dabei jeweils von den zur Bodenplatte hin orientierten Anschlagflächen der Randbereiche 23, 33 gehalten, wobei das Druckfedermittel 4 unter Druckbelastung steht, um über die innere und äußere Hohlform 2, 3 den piezoelektrischen Aktor mit einer Kraft von vorzugsweise 800 N bis 1000 N vorzuspannen.

Die becherförmige innere und äußere Hohlform 2, 3 sind im Querschnitt vorzugsweise zylinderförmig mit planen Bodenplatten 21, 22 und ringförmigen Randbereichen 23, 33 ausgebildet. Die Hohlformen können jedoch auch als Rechteck-Rohrprofil ausgeformt sein, wobei der Querschnitt der Hohlformen vorzugsweise an den Querschnitt des piezoelektrischen Aktors angepaßt ist. Als Druckfedermittel 4 wird vorzugsweise eine ringförmig, zwischen den Umfangswandungen 22, 32 der Hohlformen 2, 3 umlaufende Rohrfeder eingesetzt. Die Querschnitte der Umfangswandungen 22, 32 und der Randbereiche 23, 33, der inneren und äußeren Hohlformen 2, 3 sowie die Breite des Druckfedermittels 4 sind so ausgelegt, daß zwischen gegenüberliegenden Flächen ein ausreichendes Spiel bleibt, um bei möglichen Verformungen, z.B. aufgrund von Temperatur oder anderen Belastungseffekten eine erhöhte Reibung zwischen diesen Flächen zu vermeiden. Alternativ können die sich gegenüberliegenden Flächen der Hohlformen auch mit Materialien beschichtet werden, die sich durch einen niedrigen Reibungskoeffizienten auszeichnen. Weiterhin besteht auch die Möglichkeit, durch eine spezielle Formgebung des Druckfedermittels, z.B. durch eine Verdickung am Druckfedermittel, dafür zu sorgen, daß die beiden Hohlformen auch bei auftretenden Verformungen nicht gegeneinander reiben.

Bei den beiden Hohlformen 2, 3 können die Bodenplatten und die hülsenförmigen Umfangswandungen mit den umgebördelten Randbereichen durch kraft- und/oder formschlüssige Steckverbindungen zusammengefügt werden. Alternativ kann auch eine der Hohlformen einstückig ausgebildet sein. Weiterhin können die Bodenplatten der Hohlformen fest mit den Stirnflächen des piezoelektrischen Aktors verbunden werden.

Im Betrieb wird der piezoelektrische Aktor 1 über Kontaktstifte, die in Fig. 1 nicht gezeigt sind und vorzugsweise über in der Bodenplatte 31 der äußeren Hohlform 3 angeordnete Durchführungen aus der Aktoreinheit herausstehen, angesteuert, wobei durch Anlegen einer Spannung eine Längsdehnung im piezoelektrischen Aktor erzeugt wird, mit der z. B. ein Einspritzventil in einer Brennkraftmaschine betätigt werden kann. Die Aktoreinheit ist dabei vorzugsweise so eingebaut, daß die Längsdehnung des piezoelektrischen Aktors 1 die becherförmige innere Hohlform 2 gegen die Druckbelastung des Druckfedermittels 4 verschiebt.

Durch die Anordnung eines druckbelasteten Druckfedermittels 4 zum Vorspannen des piezoelektrischen Aktors 1 gegen dessen Längsdehnung wird die Materialbelastung auf die beiden Hohlformen im Vergleich zu einer Zugspannung auf diese Hohlformen, wie sie im Stand der Technik erfolgt, wesentlich reduziert. Die verkapselte Ausführung der Vorspanneinrichtung mit zwei ineinander gesteckten Hohlformen, die druckbelastet vom Druckfedermittel 4 beabstandet werden, ermöglicht insbesondere in bezug auf die Bauteillänge eine kompakte Ausführungsform. Weiterhin können die Wandstärken der Umfangswandungen der Hohlformen insbesondere bei der Verwendung von Federstahl, der sich durch eine hohe Materialfestigkeit auszeichnet, sehr klein gewählt werden, da die Hohlformen nur die Vorspannkräfte von vorzugsweise 800 N bis 1000 N auf den piezoelektrischen Aktor übertragen müssen und gleichzeitig sehr steif ausgebildet werden können. Dies ermöglicht eine kostengünstige Herstellung.

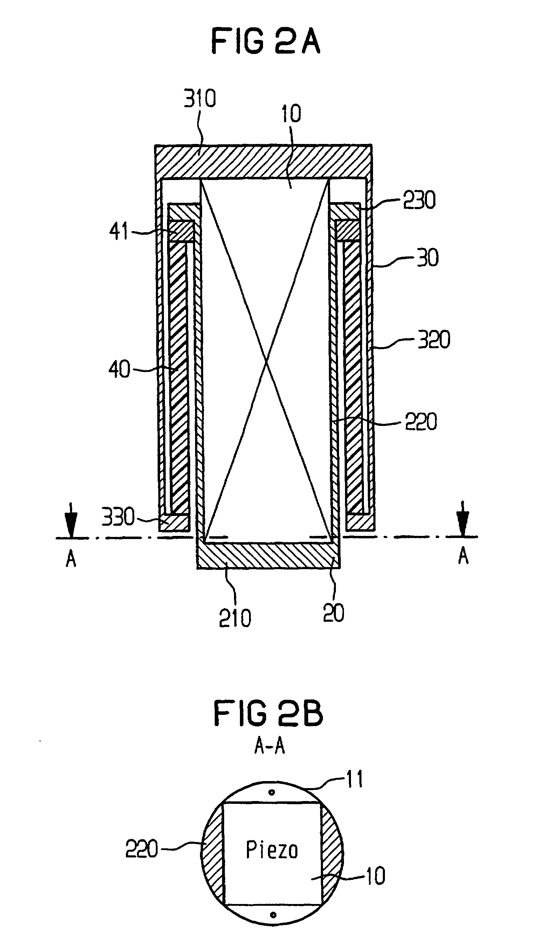

Bei der in Fig. 2A und 2B dargestellten weiteren Ausführungsform weist der piezoelektrische Aktor 10 einen rechtekkigen Querschnitt auf, wobei an zwei gegenüberliegenden Längsseiten des piezoelektrischen Aktors 10 jeweils ein Kontaktstift 11 angeordnet ist, der mit dem Aktor leitend in Verbindung steht. Im Gegensatz zur Ausführungsform gemäß Fig. 1, bei der die Umfangswandung der inneren Hohlform einen geschlossenen Querschnitt aufweist, sind bei der Ausführungsform gemäß Fig. 2A und 2B zwei sich gegenüberstehende Bügel 220 an der Bodenplatte 210 der inneren Hohlform 20 angebracht, zwischen denen der piezoelektrische Aktor 10 mit seinen beiden freien Längsseiten eingesetzt ist. Wie Fig. 2B zeigt, sind die Bügel 220 im Querschnitt vorzugsweise kreissegmentförmig ausgeformt und bilden mit dem piezoelektrischen Aktor 10 eine zylindrische Bauform. Die beiden Bügel 220 sind an ihrem oberen Ende über einen geschlossenen Ring 230 miteinander verbunden, der als Anliegebereich für das als Rohrfeder ausgebildete Druckfedermittel 40 dient. Um die Position des Druckfedermittels 40 gegen Verschiebungen, z.B. aufgrund von Belastungen der Aktoreinheit, zu sichern, ist der Ringbereich 220 mit einem Federlager 41 versehen, in das das eine Ende des Druckfedermittels 40 eingesetzt ist. Die äußere Hohlform 30 mit der Bodenplatte 310 und der Umfangswandung 320 sowie dem Randbereich 330 entspricht im wesentlichen der in Fig. 1 gezeigten Ausführungsform, wobei die äußere Hohlform vorzugsweise kreiszylindrisch ausgebildet ist. Die Ausführungsform gemäß Fig. 2A und 2B zeichnet sich durch eine besonders kompakte Bauform, insbesondere in bezug auf die Aktorbreite aus, so daß die Aktoreinheit mit einem minimalen Raumbedarf z.B. beim Einbau als Stellglied für ein Einspritzventil in einem Brennraum auskommt.

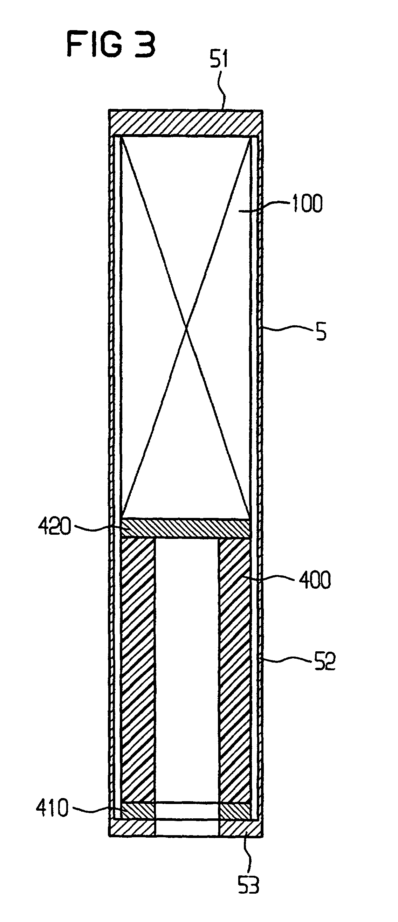

Fig. 3 zeigt eine weitere Ausführungsform der Aktoreinheit, die besonders schmal ausgebildet ist und sich so z.B. leicht in einem Schaft eines Einspritzventils einsetzen läßt. Bei dieser Ausführungsform enthält eine einzelne becherförmige Hohlform 5 den piezoelektrischen Aktor 100 und das Druckfedermittel 400, das als Rohrfeder ausgebildet ist. Die Hohlform 5, die mit ihrem Querschnitt an den Querschnitt des piezoelektrischen Aktors 100 angepaßt ist, weist an einer Stirnseite eine Bodenplatte 51 auf, an der der piezoelektrische Aktor 100 anliegt. An die Bodenplatte 51 schließt sich eine Umfangswandung 52 an, die von einem nach innen ragenden umlaufenden Randbereich 53 abgeschlossen wird. Dieser Randbereich 53 ist vorzugsweise ringförmig ausgebildet, so daß sich mittig eine kreisförmige Öffnung ergibt. An der Innenfläche des Randbereiches 53 ist das Druckfedermittel 400 mit seinem einen Ende abgestützt, wobei der Randbereich vorzugsweise mit einem Federlager 410 zur Positionssicherung versehen ist. Das Druckfedermittel 400 ist mit seinem anderen Ende gegen den piezoelektrischen Aktor 100 abgestützt, wobei zwischen piezoelektrischen Aktor und Druckfedermittel zusätzlich ein Federanschlag 420 vorgesehen ist. Die Länge der Hohlform 5 ist so ausgelegt, daß das Druckfedermittel 400 unter Druckbelastung steht und den piezoelektrischen Aktor 100 vorzugsweise mit einer Kraft von 800 N bis 1000 N vorspannt.

Wenn der piezoelektrische Aktor 100 über Kontaktstifte (nicht gezeigt) angesteuert wird, so dehnt sich der Aktor gegen die Haltekraft des Druckfedermittels 400 aus und bewegt den Federanschlag 420 in Richtung auf den Randbereich 53 der Hohlform 5. Diese Längsdehnung des piezoelektrischen Aktors 100 kann z.B. zum Stellen eines Einspritzventils in einer Brennkraftmaschine eingesetzt werden, indem mittels einer Stange (nicht gezeigt), die durch die im Randbereich 53 vorgesehene Öffnung und das als Ringfeder ausgebildete Druckfedermittel 410 zum Federanschlag 420 reicht, die Ausdehnung des Aktors zum Öffnen oder Schließen des Ventils genutzt wird. Alternativ kann die Längsdehnung des piezoelektrischen Aktors jedoch auch hydraulisch übertragen werden.

Gemäß der Erfindung ist die Aktoreinheit so ausgelegt, daß der piezoelektrische Aktor durch ein Druckfedermittel gegen seine Dehnungsrichtung druckbelastet vorgespannt ist. Dabei wird die Rohrfeder 400 auf Druck belastet, so daß eine Reduzierung der Materialbelastung auf die Vorspanneinrichtung insbesondere die Rohrfeder 400 erfolgt und somit eine lange Lebensdauer des Bauteils gewährleistet wird. Weiterhin ist der Aktor in einer Vorspanneinrichtung eingekapselt, so daß die Vorspannung auf dem piezoelektrischen Aktor fest voreingestellt werden kann, wodurch sich Transport und Montage vereinfachen.

## Patentansprüche

1. Aktoreinheit mit einem piezoelektrischen Aktor (1; 10; 100) und einer elastischen Vorspanneinrichtung (2, 3, 4; 20, 30, 40; 5, 400), die den piezoelektrischen Aktor vorspannt,
wobei
die Vorspanneinrichtung den piezoelektrischen Aktor umfaßt und ein Federmittel (4, 40; 400) aufweist, das als Rohrfeder ausgebildet ist und das den piezoelektrischen Aktor gegen seine Ausdehnungsrichtung druckbelastet, **dadurch gekennzeichnet, daß** das Federmittel (4, 40, 400) als Druckfedermittel (4, 40,400) auf Druck belastet ist.

2. Aktoreinheit gemäß Anspruch 1, **dadurch gekennzeichnet, daß** die Vorspanneinrichtung zwei Hohlformen (2, 3; 20, 30) aufweist, die im Querschnitt becherförmig sind und den piezoelektrischen Aktor (1; 10) einschließen, wobei die Hohlformen durch das Druckfedermittel (4; 40) beabstandet sind.

3. Aktoreinheit gemäß Anspruch 2, **dadurch gekennzeichnet, daß** die erste Hohlform (2; 20) einen nach außen vorspringenden Randbereich (23; 230) und die zweite Hohlform (3; 30) einen nach innen vorspringenden Randbereich (33; 330) aufweisen, wobei die erste Hohlform in die zweite Hohlform eingreift und das Druckfedermittel (4; 40) zwischen den Randbereichen der Hohlformen eingespannt ist.

4. Aktoreinheit gemäß Anspruch 3, **dadurch gekennzeichnet, daß** die erste und die zweite Hohlform (2, 3; 20, 30) zylindrisch ausgeformt sind.

5. Aktoreinheit gemäß Anspruch 3, wobei die erste Hohlform (20) aus einer Bodenplatte (210) und zwei darin anschließenden Bügeln (220), die durch einen nach außen vorspringenden Ringbereich (230) abgeschlossen sind, besteht.

6. Aktoreinheit gemäß einem der Ansprüche 2 bis 5, wobei die Hohlformen mit Beschichtungen, die einen niedrigen Reibungskennwert aufweisen, an einander gegenüberliegenden Flächen versehen sind.

7. Aktoreinheit gemäß Anspruch 1, **dadurch gekennzeichnet, daß** die Vorspanneinrichtung eine becherförmige Hohlform (5) aufweist, die den piezoelektrischen Aktor (100) und das Druckfedermittel (400) einschließt, wobei ein umlaufender nach innen vorspringender Randbereich (53) der becherförmigen Hohlformen das Druckfedermittel gegen den piezoelektrischen Aktor abstützt.

## Claims

1. Actuator unit with a piezo-electric actuator (1; 10; 100) and an elastic biasing means (2, 3, 4; 20, 30, 40; 5, 400) which biases the piezo-electric actuator,
whereby
the biasing means encompasses the piezo-electric actuator and has a spring means (4, 40; 400) which is designed as a Bourdon spring and which pressure-loads the piezo-electric actuator against its direction of expansion, **characterized in that** the spring means (4, 40, 400) is pressure-loaded as a pressure spring means (4, 40, 400).

2. Actuator according to Claim 1, **characterized in that** the biasing means has two hollow shapes (2, 3; 20, 30) which are beaker-shaped in cross-section and enclose the piezo-electric actuator (1; 10), whereby the hollow shapes are held at a distance by the pressure spring means (4; 40).

3. Actuator unit according to Claim 2, **characterized in that** the first hollow shape (2; 20) has an edge area (23, 230) protruding outward and the second hollow shape (3; 30) has an edge area (33; 330) protruding inward, whereby the first hollow shape engages in the second hollow shape and the pressure spring means (4; 40) is clamped between the edge areas of the hollow shapes.

4. Actuator unit according to Claim 3, **characterized in that** the first and the second hollow shape (2, 3; 20, 30) are cylindrical in shape.

5. Actuator unit according to Claim 3, whereby the first hollow shape (20) consists of a base plate (210) and two brackets (220) connecting therein which are terminated by an annular area (230) protruding outward.

6. Actuator unit according to one of Claims 2 to 5, whereby the hollow shapes are provided on opposite surfaces with coatings which have a low friction characteristic.

7. Actuator unit according to Claim 1, **characterized in that** the biasing unit has a beaker-shaped hollow shape (5) which encloses the piezo-electric actuator (100) and the pressure spring means (400), whereby a circumferential, inwardly protruding edge area (53) of the beaker-shaped hollow shapes braces the pressure spring means against the piezo-electric actuator.

## Revendications

1. Unité d'actionneur comprenant un actionneur piézoélectrique (1 ; 10 ; 100) et un dispositif de précontrainte élastique (2, 3, 4 ; 20, 30, 40 ; 5, 400) qui précontraint l'actionneur piézoélectrique, dans laquelle le dispositif de précontrainte renferme l'actionneur piézoélectrique et présente un moyen formant ressort (4, 40 ; 400) qui est constitué par un ressort tubulaire et qui sollicite l'actionneur piézoélectrique par une contrainte en compression en sens inverse de sa dilatation, **caractérisée en ce que** le moyen formant ressort (4, 40, 400), constituant un moyen formant ressort de compression (4, 40, 400) est chargé en compression.

2. Unité d'actionneur selon la revendication 1, **caractérisée en ce que** le dispositif de précontrainte présente deux éléments creux (2, 3 ; 20, 30) qui ont une section en forme de godet et entourent l'actionneur piézoélectrique (1 ; 10), les éléments creux étant maintenus espacés par le moyen formant ressort de compression (4 ; 40).

3. Unité d'actionneur selon la revendication 2, **caractérisée en ce que** le premier élément creux (2 ; 20) présente une zone marginale (23 ; 230) en saillie vers l'extérieur et le deuxième élément creux (3 ; 30) présente une région marginale (33 ; 330) en saillie vers l'intérieur, le premier élément creux étant engagé dans le deuxième élément creux et le moyen formant ressort de compression (4 ; 40) étant serré entre les régions marginales des éléments creux.

4. Unité d'actionneur selon la revendication 3, **caractérisée en ce que** le premier et le deuxième éléments creux (2, 3 ; 20, 30) sont de forme cylindrique.

5. Unité d'actionneur selon la revendication 3, dans laquelle le premier élément creux (20) est composé d'une plaque de fond (210) et de deux étriers (220) qui y font suite et qui sont terminés par une région annulaire (230) en saillie vers l'extérieur.

6. Unité d'actionneur selon une des revendications 2 à 5, dans laquelle les éléments creux sont munis sur des surfaces mutuellement opposées de revêtements qui présentent un faible coefficient de frottement.

7. Unité d'actionneur selon la revendication 1, **caractérisée en ce que** le dispositif de précontrainte présente un élément creux (5) en forme de godet qui entoure l'actionneur piézoélectrique (100) et le moyen formant ressort de compression (400), une région marginale périphérique (53) en saillie vers l'extérieur, des éléments creux en forme de godet donnant appui à l'élément formant ressort en agissant à l'encontre de l'actionneur piézoélectrique.
